# EUROPEAN PATENT APPLICATION

(11) **EP 4 683 469 A1**
(43) Date of publication of application: **21.01.2026**
(21) Application number: 24461595.1
(22) Date of filing: 15.07.2024
(51) Int. Cl.: H10K 30/81, H10K 77/10, H10K 50/805

(54) **A METHOD FOR MANUFACTURING AN OPTOELECTRONIC FOIL, AN OPTOELECTRONIC FOIL AND AN OPTOELECTRONIC DEVICE COMPRISING THE OPTOELECTRONIC FOIL**

(71) Applicant: Saule S.A., 54-427 Wroclaw (PL)
(72) Inventor: WOJCIECHOWSKI, Konrad, Wroclaw (PL); SCIGAJ, Mateusz, Wroclaw (PL)
(74) Representative: Kancelaria Eupatent.pl Sp. z o.o.

(57) **Abstract**

A method for manufacturing an optoelectronic foil, characterized by comprising the steps of: a) providing a substrate (12) having a first side (12a) and a second side (12b), b) disposing a barrier layer (11) on the substrate (12), wherein the barrier layer (11) has a first side (11a) and a second side (11b), and wherein the second side (11b) of the barrier layer (11) is adjacent to the first side (12a) of the substrate (12), c) disposing an electrode layer (13) on the second side (12b) of the substrate (12), d) treating the electrode layer (13) to provide a structured electrode layer (13').

## Description

### TECHNICAL FIELD

The present disclosure relates to the field of optoelectronic foils, methods for their fabrication and optoelectronic devices comprising optoelectronic foils.

### BACKGROUND

Optoelectronic devices, such as photovoltaic cells, light-emitting diodes (LEDs), organic photodetectors, and the like are commonly used in various applications in fields of telecommunication, consumer electronics, medical technology, industry, automotive and renewable energy. They typically offer numerous benefits, like energy efficiency, reliability and versatility. However, these devices are often vulnerable to environmental factors such as moisture, oxygen, and other contaminants that can degrade their performance over time. That is why, the optoelectronic devices are usually equipped with optoelectronic foils containing barrier structures, so that the ingress of unwanted factors is reduced. Additionally, the optoelectronic foils usually contain conductive electrode structures, to improve their functionality, especially when used in the optoelectronic devices. The barrier structures contained in the optoelectronic foils are helpful in protecting sensitive parts of the optoelectronic devices. However, these barrier structures are vulnerable themselves to other external factors. There is an ongoing issue of ensuring that barrier structures of the optoelectronic foils are not exposed to damage during the optoelectronic foil production process, especially during the step of depositing or treating the conductive electrode structures, to prevent the barrier structures from being mechanically damaged or scratched, which in turn would increase the risk of deteriorating their barrier properties. The barrier structures of the optoelectronic foils are also vulnerable to potential damage during manufacturing processes of the optoelectronic devices formed directly on the optoelectronic foils. The abovementioned problem is especially relevant in most common solutions applied in optoelectronic devices, more particularly photovoltaic devices, in which according to general teaching, the barrier structures should be placed close to the sensitive, photoactive areas, which makes them more exposed to potential damage.

From the patent literature, there are known methods for manufacturing thin, foil-like multilayer optoelectronic films for optoelectronic devices. There are also known optoelectronic films and optoelectronic devices comprising optoelectronic films.

Publication of US patent application US20180040393A1 discloses a light transmitting film including, in this order, a transparent substrate, a protection layer and a conductive, light transmitting inorganic layer and a method for its manufacture. The transparent substrate is composed of a polymer film. The protection layer is prepared from a resin composition and works as an abrasion protection layer for avoiding abrasions on the top face of the light transmitting inorganic layer. The conductive layer is provided on the protection layer. The manufacturing process of the disclosed light transmitting film includes a step of providing a patterned portion and a non-patterned portion of the conductive layer by etching portions of the conductive layer. An etching solution capable of dissolving at least part of the conductive layer is applied on its top surface. In this manner, a non-patterned portion and a patterned portion are formed on the protection layer. During the etching process the protection layer underlying the etched conductive layer is at risk of damage. In case of damaging the protection layer, it will likely lose its barrier properties. This constitutes a significant drawback of the solution.

European patent EP3645285 B1 discloses a functional multi-layer assembly and a process for its production. The invention relates to permeation barrier films and encapsulation films, particularly those suitable to be used as packaging or as a substrate or element in electronic devices. The document discloses a multi-layer assembly, which contains a polymeric base layer, a functional layer and a polymeric protective layer, in this order, and a method of its manufacture. The disclosed manufacturing process aims to increase protection of a surface of a multilayer substrate comprising the functional layer from contamination or debris. Typical functional layers include permeation barrier layers, electrically conductive layers, thermally conductive layers, optical adjustment layers, semiconductor layers and photoactive layers, as well as other electronically active layers. The disclosed invention aims to retain the surface of the functional layer free from defects and damage induced by downstream processing, such as by the deposition of subsequently applied further functional layers, particularly conductive layers. The process comprises the steps of providing a composite film comprising the base layer and the protective layer, removing said protective layer from the surface of said base layer, disposing on the exposed surface of said base layer one or more functional layers to provide the multi-layer substrate and disposing the protective layer on the functional layers of the multilayer substrate. This document also discloses an electronic device comprising the multilayer assembly and one or more conductive layer(s) and/or semiconductor layer(s) disposed within or on said multilayer assembly, such that the conductive and/or semiconductive layer(s) are disposed onto the surface of the protective layer of said multi-layer assembly. The polymeric protective layer is provided between the functional layer and the conductive layer in order to protect the surface of the functional layer. Such arrangement requires to provide additional layer between the functional layer and the conductive layer, which adds complexity and cost to the process.

Publication of US patent application US20100304048 A1 discloses a flexible transparent conductive film, flexible functional device, and methods for producing these. The flexible transparent conductive film comprises a base film provided with barrier function and a transparent conductive layer formed by coating a surface of the base film. The flexible transparent conductive film has a backing film laminated on the other side of the base film in such a way as to be peelable at the interface thereof with the base film. The transparent conductive layer is disposed on the base film surface on its side opposite to the backing film. The base film may be coated with the transparent conductive layer forming coating fluid by either of whole-area coating (solid printing) and pattern printing. Also disclosed is a flexible functional device formed on said flexible transparent conductive film. The functional device may be selected from a liquid-crystal display device, an organic electroluminescent device, a dispersion-type inorganic electroluminescent device and an electronic paper device. The disclosed solution aims to provide a flexible conductive film with barrier properties, in which the barrier function is not deteriorated due to compressing of the film, so that it is applicable on flexible electronic devices. However, having the conductive layer directly in contact with the base film having been provided with barrier function increases a risk of damaging the barrier layer when operations are performed on the conductive layer, such as patterning the conductive layer.

The international patent application WO2021232682 A1 discloses a flexible solar cell and a preparation method thereof. This disclosure aims to provide a flexible solar cell with improved water-oxygen barrier property and a higher stability by providing a barrier structure consisting of two encapsulation layers, which are sandwiching layers of the solar cell. The disclosed order of layers in the stack of the flexible solar cell from bottom to top is as follows: a first encapsulation layer, a flexible PET substrate, a first electrode layer, an electron transport layer, a perovskite photoactive layer, a hole transport layer, a second electrode layer, a second encapsulation layer, a PET layer. The material used for the encapsulation layers is aluminum oxide (Al₂O₃), and the preparation method is atomic layer deposition. In addition, the first encapsulation layer and the second encapsulation layer can be further covered with conventional encapsulating materials such as EVA, ultraviolet encapsulating glue, organic silicone, etc., which is supposed to improve the encapsulation effect. This disclosure aims to provide a fully encapsulated solar cell, and the first and the second encapsulation layers are deposited at the end of the solar cell manufacturing process. This present certain drawbacks, since the deposition of the encapsulation layers is typically carried out in relatively high temperature, which may negatively influence the sensitive perovskite photoactive layer already present in the device. Also the disclosed manufacturing process is not suitable for manufacturing optoelectronic foils, but it is limited to manufacturing whole PV devices, in which both first and second encapsulation layers are formed in the same process step and are designed to cover the entire solar cell stack. In fact, this disclosure is silent about providing an optoelectronic foil with improved functionality by comprising structured electrode, which optoelectronic foil is suitable to be applied in optoelectronic devices.

The above-mentioned solutions made some contribution to the described technical field of optoelectronic foils and methods for manufacturing optoelectronic foils. However, they present certain limitations when it comes to provide a safer and less invasive manufacturing process of the optoelectronic foil, in which the risk of inadvertently damaging individual layers of the foil is reduced and the process being applicable in large scale operations while maintaining effective protection of optoelectronic devices against moisture and external factors by the obtained optoelectronic foil. The currently known solutions present challenges related to obtaining an optoelectronic foil of improved functionality comprising conductive electrode structures and barrier structures which are less vulnerable to damage caused by downstream manufacturing steps, such as by performing treatment of the conductive layers present in the optoelectronic foil to improve its functionality. These challenges lie in the necessity for the barrier layer to be as close to the sensitive parts of the devices as possible, while still ensuring that the electrode can be structured for proper device function.

### SUMMARY OF THE INVENTION

Therefore, it would be desirable to address at least some of the limitations of the known solutions, including reducing the risk of deterioration of the barrier properties of the optoelectronic foils by unintentionally damaging barrier structures contained therein during successive manufacturing steps, such as depositing or treating electrode structures to provide an optoelectronic foil with improved functionality. The technical problem of the present invention is to propose a method for manufacturing an optoelectronic foil and to propose an optoelectronic foil being suitable to be applied as a component in an optoelectronic device, such as a photovoltaic device, which would have improved functionality and would provide increased protection against moisture and other external atmospheric and mechanical factors. It is desirable that the manufacturing method of the optoelectronic foil is more applicable in mass production and less invasive, so that the barrier structures of the optoelectronic foil have more continuous surfaces and are less exposed to damage when carrying out successive manufacturing steps. Moreover, it is also desirable that the optoelectronic foil is resistant to mechanical damage while maintaining its properties and provides improved functionality due to presence of electrode structures, which may additionally be treated in order to provide structured electrodes, which further increases functionality and practicality of the optoelectronic foil. It is desirable, that the optoelectronic foil manufacturing method has a limited number of technological steps, so as to directly provide economic benefits of a simplified, less time-consuming and thus cheaper process. It is desirable that the exposure of the barrier structures to potential damage during the electrode treatment process to provide the structured electrode with improved functionality is reduced. Another technical problem of the present invention is to provide an optoelectronic device with enhanced barrier protection against environmental and mechanical factors, which potentially prolongs its lifespan and increases reliability.

To address at least some of the limitations of prior art solutions, the present invention introduces a manufacturing method of a high-performance optoelectronic foil, that provides superior protection against environmental degradation while maintaining proper transparency and electrical properties. The optoelectronic foil is designed to be flexible, durable, and easily integrable into various optoelectronic devices, ensuring prolonged device life and consistent performance. The optoelectronic foil according to the invention effectively lowers the ingress of moisture and oxygen, which are primary contributors to the degradation of sensitive components of the optoelectronic devices. By incorporating this optoelectronic foil into optoelectronic devices, significant improvements in device stability, efficiency, and overall lifespan is achieved. The optoelectronic foil is of improved functionality, since it is equipped with the electrode layer. A significant advantage of the disclosed optoelectronic foil is its specific layer architecture, which provides an excellent protection against moisture and other external factors while also allowing for obtaining the structured electrode layer by treating the electrode layer with reduced risk of damaging the barrier layer. The architecture of the optoelectronic foil also allows for subsequent process steps of manufacturing the optoelectronic device on the optoelectronic foil with reduced risk of damaging the barrier layer.

There is presented a method for manufacturing the optoelectronic foil, the optoelectronic foil and the optoelectronic device with the optoelectronic foil according to the appended claims.

In one aspect, the invention relates to a method for manufacturing the optoelectronic foil. The method comprises a step of providing a substrate which includes a first side and a second side. Next, the method comprises a step of disposing a barrier layer on the substrate wherein the barrier layer includes a first side and a second side, and wherein the second side of the barrier layer is adjacent to the first side of the substrate. Moreover, the method comprises a step of disposing an electrode layer on the second side of the substrate, which is opposite to the first side on which the barrier layer is disposed. Next step of the method is a step of treating the electrode layer to provide a structured electrode layer.

The method comprising the steps according to the present disclosure allows to obtain the optoelectronic foil with increased functionality. The optoelectronic foil obtained according to the method of the present disclosure provides increased protection against moisture, oxygen and other environmental factors by applying the barrier layer on the substrate. Barrier structures are crucial in order to limit degradation of active materials of optoelectronic devices and increase their performance and lifespan. Also, the functionality of the optoelectronic foil is increased by applying the electrode layer on the substrate, which provides necessary electrical connection to the optoelectronic device and ensures efficient charge transport due to minimized resistive losses, which is crucial for the device performance. The optoelectronic foil manufactured according to the method of the present disclosure comprises the structured electrode layer, after the electrode layer is treated according to one of the steps of the presented method. The structured electrodes offer optimized performance, functionality and efficiency of optoelectronic devices, since they provide better electrical charge distribution and reduced resistive loses. The optoelectronic foil comprising the structured electrode layer is particularly suitable for use in optoelectronic devices, such as photovoltaic devices, in which the structured electrode layers involving grooves or scribe lines provide electrical isolation between adjacent solar cells on the same substrate. By isolating adjacent solar cells it is ensured that each cell operates independently and efficiently. Structured electrode layer also facilitates interconnection of solar cells to form photovoltaic modules comprising said solar cells connected in series or in parallel, so that the overall voltage or current output of the photovoltaic module is increased. The step of treating the electrode layer in order to provide the structured electrode layer is a fundamental step that contributes to the overall efficiency and performance of the solar module. This step is typically carried out by laser ablation, chemical etching or mechanical scribing and may be invasive for adjacent layers. The method according to the present disclosure allows to produce the optoelectronic foil in which the electrode layer and the barrier layer are separated by the substrate. This allows to perform the steps of disposing and treating the electrode layer with reduced risk of damaging the barrier layer, so that the barrier properties of the optoelectronic foil are retained. The optoelectronic foil manufactured according to the disclosed method comprises the barrier layer, which is not damaged by the electrode deposition process and by the step of treating the electrode layer. The barrier layer is also at less risk of being damaged during the process of manufacturing the optoelectronic device on the optoelectronic foil. The optoelectronic foil manufacturing method has a limited number of technological steps, which provides economic benefits of a simplified, less time-consuming and thus cheaper process.

Preferably, the method according to the present disclosure comprises a step of applying a protective layer on the barrier layer. Preferably, the protective layer is disposed on the first side of the barrier layer, which is opposite to the second side of the barrier layer being adjacent to the substrate. The protective layer is disposed on the barrier layer on the opposite side to the substrate. The step of applying the protective layer on the barrier layer is performed after the step of disposing the barrier layer on the substrate. Preferably, the step of applying the protective layer on the barrier layer is performed directly after the step of disposing the barrier layer on the substrate. The protective layer provides protection to the barrier layer from mechanical damage, such as mechanical abrasion. A foil with the barrier layer covered with the protective layer is more suitable for subsequent manufacturing steps needed to form the optoelectronic foil according to the present disclosure. It may be rolled up and/or turned around to deposit and treat subsequent layers, such as the electrode layer to form the optoelectronic foil, or further layers, such as photoactive layers, electron and/or hole transporting layers to form the optoelectronic device. The protective layer provides additional protection for the optoelectronic foil. The optoelectronic foil equipped with the protective layer exhibits better durability and more consistent performance, since the likelihood of damage is reduced. The protective layer also provides additional protection for the optoelectronic device. The optoelectronic device equipped with the optoelectronic foil comprising the protective layer demonstrates extended lifespan, since its sensitive elements are shielding from abrasion, impact, and other external factors, that could compromise its integrity. The step of applying the protective layer may alternatively be performed before or after the step of disposing the electrode layer on the second side of the substrate. This step may also be performed before or after the step of treating the electrode layer to provide the structured electrode layer.

Preferably, the step of treating the electrode layer includes at least one technique selected from the group consisting of: laser ablation, chemical etching, mechanical scribing.

The step of treating the electrode layer enables forming the structured electrode layer, which structured electrode layer comprises discontinuities created by cuts, resulting in separate, electrically isolated electrode regions on the surface of the electrode layer. Such arrangement aims to minimize electrical resistance of the electrode layer and provide optimized performance, functionality and efficiency of optoelectronic devices, since they provide better electrical charge distribution and reduced resistive loses. The optoelectronic foil with such structured electrode layer is particularly suitable for use in photovoltaic devices in which the structured electrode layers involving grooves or scribe lines provide electrical isolation between adjacent solar cells on the same substrate. The charge carriers generated in the photovoltaic device are efficiently collected and transported in order to enhance the efficiency in converting sunlight into electrical energy. Structured electrode layer also facilitates interconnection of solar cells to form photovoltaic modules comprising said solar cells connected in series or in parallel. Series connection of solar cells in photovoltaic modules allow to multiply the voltage generated by each of the solar cells, so that the overall voltage provided by the photovoltaic module is increased. Parallel connection of solar cells (or strings of solar cells) allows to multiply the current output (from each connected string of solar cells).

Preferably, the step of treating the electrode layer is performed by laser ablation, which removes material from a solid surface of the electrode layer by irradiating it with a laser beam, enabling precise and controlled treatment. Laser ablation offers high precision and control in electrode layer treatment, enabling complex designs that enhance efficiency of the optoelectronic device. Additionally, it is a clean, contactless process that minimizes damage to the material, ensuring better performance and longevity of the optoelectronic foil. Preferably, the step of treating the electrode layer is performed by chemical etching, which involves using corrosive chemicals to selectively remove material of the electrode layer from the substrate, creating precise patterns and structures. Chemical etching provides a uniform treatment of electrode layer, aiming to provide desired surface properties. It is also a cost-effective method that allows for large-scale production while maintaining high-quality results. Preferably the step of treating the electrode layer is performed by mechanical scribing, which is a process that uses a sharp tool to physically score or cut a material of the electrode layer to create precise patterns and structures. Advantages of this method include its simplicity and cost-effectiveness, as well as the ability to produce clean and accurate cuts without the need for complex equipment. Additionally, mechanical scribing is versatile and can be applied to a wide range of materials. The abovementioned electrode layer treating processes are particularly suitable, since they enable obtaining the desired effect of providing the structured electrode layer. They may be harmful for neighboring layers, especially layers comprising sensitive materials, such as barrier layers. Barrier layers damaging is undesired, as a damaged barrier layer present in the optoelectronic foil would have detrimental effect for the optoelectronic device equipped with such optoelectronic foil. The presented method for manufacturing an optoelectronic foil, in which the electrode layer is separated from the barrier layer by the substrate reduces the risk of damaging the barrier layer, which is less vulnerable to potentially harmful electrode layer treatment processes.

Preferably, the barrier layer and the electrode layer are deposited on the substrate using the same technique.

Preferably, the barrier layer and the electrode layer are deposited on the substrate using the sputtering technique. Sputtering technique allows to fabricate high quality layers of wide range of materials with smooth surfaces and uniform thicknesses and may be applied in mass production since it may be applied on large-area surfaces and offer repeatability and can be automated. Preferably, the barrier layer and the electrode layer are deposited on the substrate using the atomic layer deposition technique (ALD). This technique offers high precision and uniformity of formed layers and is capable to be applied in large scale operation due to automation possibilities, high quality layer formation and versatility when it comes to materials that can be deposited using this technique. Preferably, the barrier layer and the electrode layer are deposited on the substrate using the same technique. The optoelectronic foil according to this disclosure comprises the barrier layer and the electrode layer, which are separated by the substrate. The impact on the barrier layer of the deposition method selected to fabricate the electrode layer is reduced. Also, the impact on the electrode layer of the deposition method selected to fabricate the barrier layer is reduced. The ability to deposit the barrier layer and the electrode layer using the same technique provides a benefit of simplifying the production process, as a single machine may be used. Also it introduces technological advantages, since the process may be faster, less complicated and cheaper. Alternatively, the barrier layer and the electrode layer are deposited on the substrate using different techniques. As such, preferably the barrier layer is deposited using the ALD technique, since it allows to form dense and compact layers, yielding high potential for good barrier properties, and the electrode layer is deposited using the sputtering technique. These techniques are particularly suitable to form the respective layers.

Preferably, the barrier layer is of a monolayer structure or a multilayer structure. Preferably, the barrier layer is of a monolayer structure and consists of a barrier monolayer. The monolayer barrier structures are simpler to fabricate, as they require less manufacturing steps, which need precise process engineering and control. The barrier layer of the monolayer structure according to the present disclosure provides enhanced protection from oxygen, moisture and other potentially harmful factors that may penetrate through the optoelectronic foil towards the optoelectronic device. Preferably, the barrier layer is of a multilayer structure and comprises barrier sublayers. The multilayer barrier structure enables versatility and customization, as properties of single materials forming part of the multilayer structure may be multiplied. Similarly to the monolayer structure, the barrier layer of the multilayer structure provides enhanced protection from oxygen, moisture and other potentially harmful factors that may penetrate towards the optoelectronic device.

Preferably, the barrier layer has a total thickness of 5 nm to 150 nm. The thickness of the barrier layer selected from the abovementioned range is beneficial, since it allows to obtain desired barrier properties, as well as transparency. Preferably, the thickness of the barrier layer having the monolayer structure is selected from the range of 5 nm to 120 nm, such as but not limited to 5 nm to 50 nm when the barrier layer is formed by ALD technique and 40 nm to 120 nm when the sputtering technique is used. The thickness of the barrier layer selected from this range is particularly beneficial, since not only it enables desired barrier and transparency properties, but also it allows to use less material and assists in making the optoelectronic foil more flexible and lighter. Preferably, the barrier layer has two barrier sublayers and has the total thickness of 5 nm to 150 nm, such as but not limited to 5 nm to 50 nm, when the barrier sublayers are formed by ALD technique, and 50 nm to 150 nm, when the barrier sublayers are formed by sputtering technique.

Preferably, the electrode layer is of a monolayer structure or a multilayer structure. Preferably, the electrode layer is of a monolayer structure. As such, in some embodiments the electrode layer consists of an oxide layer comprising a material selected from the group of transparent conductive oxides. Such arrangement of the electrode layer provides desired conductivity, high transmittance and it is easier to manufacture, as less process steps are required compared to multilayer structures.

Preferably the electrode layer is of the multilayer structure and comprises a combination of sublayers. As such, in some embodiments the electrode layer comprises a metal layer and the oxide layer, wherein the metal layer is adjacent to the substrate and the oxide layer is adjacent to the metal layer and is facing away from the substrate. Such arrangement provides enhanced conductivity due to the presence of the metal layer. Additionally, the presence of the one oxide layer in the electrode layer is beneficial, since it may protect the metal layer from oxidation.

Preferably, the electrode layer of the multilayer structure comprises the metal layer and two oxide layers, such that the metal layer is sandwiched between the two oxide layers, so that the first oxide layer is adjacent to the substrate and is in contact with one side of the metal layer, and the second oxide layer is facing away from the substrate and is in contact with second side of the metal layer. Such arrangement provides improved optoelectronic properties, such as higher conductivity. It also enables an option to tune light transmission range in the visible spectrum by properly designing layer thicknesses. Additionally, the presence of the at least one oxide layer adjacent to the metal layer provides better matching of refractive index to the neighboring layers, which results in reduced light reflection.

Preferably, the metal layer comprises a single metal material. Preferably, the metal layer comprises more than one metal materials, such as two. The more than one metal materials within the metal layer may be formed by co-deposition, such as co-sputtering of more than one metal materials, such as two metal materials to form a single metal layer. The more than one metal materials within the metal layer may be deposited one on another, to form metal sublayers, such that one of the metal sublayers forms a seeding layer for the subsequent metal sublayer. The metal layer comprising the single metal material requires less materials or less steps are needed for its formation. The metal layer comprising more than one metal materials provides an advantage of increased conductivity and may provide better uniformity of the metal layer. Preferably, the metal layer comprises two metal materials. The number of metal materials within the metal layer is not particularly limited and may be selected according to the specific needs, as long as desired conductivity and transparency is obtained.

Preferably, the oxide layer comprises a single oxide material. Preferably, the oxide layer comprises more than one oxide materials, such as two, to form oxide sublayers within the oxide layer structure. The presence of more than one oxide materials within the oxide layer may further enhance the transmission of light through the structure and reduce reflection, which is beneficial in optoelectronic devices.

It should be noted, that the architecture of the electrode layer is not particularly limited. The properties of the electrode layer may be further increased by providing arrangements comprising sandwiched structures of more than one metal layers and more than two oxide layers. One non limiting example is an arrangement of two metal layer and three oxide layers, in which each of the two metal layers is sandwiched by the oxide layers, and the arrangement is as follows: oxide layer, metal layer, oxide layer, metal layer, oxide layer. Such an arrangement may further optimize performance across different wavelengths of light, making more effective use of the full solar spectrum. Each layer can have different electrical and optical properties, allowing for better customization of the electrode layer parameters to meet specific device needs. Finally, the use of multiple layers provides greater design flexibility, enabling the adaptation of devices to various applications and operating conditions.

Preferably, the electrode layer has a total thickness of 10 nm to 500 nm. The thickness of the electrode layer selected from the abovementioned range is suitable, since it allows to obtain desired electrode layer properties, such as conductivity, transparency and resistance. Additionally, the thickness of the range above provides a robust electrode layer capable of withstanding mechanical stresses while maintaining efficient charge transport, enhancing the overall durability and longevity of the optoelectronic device. The electrode layer of the monolayer structure consisting of the oxide layer preferably has a thickness of 20 nm to 500 nm, and more preferably 60 nm to 300 nm. Such thickness range of the electrode layer of the monolayer structure ensures high conductivity and transparency, making it particularly suitable in optoelectronic applications, such as in photovoltaic devices. The electrode layer of the multilayer structure comprising at least one metal layer and at least one oxide layer preferably has a thickness of 10 nm to 200 nm. As such, the metal layer preferably has a thickness of 4 nm to 12 nm, and the oxide layer within such multilayer structure has a thickness of 1 nm to 60 nm. In some embodiments of the electrode layer of the multilayer structure comprising the metal layer sandwiched between two oxide layers, the first oxide layer provided adjacent to the substrate and in contact with one side of the metal layer preferably has a thickness of 1 nm to 60 nm. The second oxide layer facing away from the substrate and in contact with second side of the metal layer preferably has a thickness of 5 nm to 60 nm. As such, preferably the electrode layer has the total thickness of 10 nm to 132 nm.

In another aspect, the invention relates to an optoelectronic foil for an optoelectronic device, obtainable by the method according to the present disclosure. The disclosed optoelectronic foil comprises a substrate which includes a first side and a second side, a barrier layer disposed on the substrate, an electrode layer disposed on the substrate, so that the barrier layer and the electrode layer are deposited on the opposite sides of the substrate. Such arrangement of the optoelectronic foil allows to limit the penetration of oxygen, moisture and other external factors towards the optoelectronic device equipped with the optoelectronic foil obtainable by the disclosed method. This arrangement of the optoelectronic foil provides reduced risk that the barrier layer is exposed to damage resulting from deposition or treatment of successive layers of the optoelectronic device which is formed on the optoelectronic foil, because the barrier layer is separated from the layers of the optoelectronic device by the substrate. Also, this arrangement provides reduced risk of damaging the barrier layer by deposition and treatment of the electrode layer, which forms part of the optoelectronic foil. The electrode layer is therefore suitable to be treated using various techniques, even those considered invasive, with reduced risk of damaging the barrier layer. This is particularly important because the barrier layer preferably has a uniform and undamaged surface to perform its function properly. The structured electrode layer of the optoelectronic foil provides increased functionality of the optoelectronic foil. The optoelectronic foil obtainable by the method according to the present disclosure comprises the barrier layer, which is uniform and undamaged by subsequent manufacturing processes.

In another aspect, the invention relates to an optoelectronic foil of improved functionality, which comprises a substrate having a first side and a second side, a barrier layer and a structured electrode layer. The structured electrode layer is separated from the barrier layer by the substrate, so that the barrier layer is adjacent to the first side of the substrate and the structured electrode layer is adjacent to the second side of the substrate. The structured electrode layer provides optimized performance, functionality and efficiency of optoelectronic devices, as it was described earlier. The barrier layer provides increased functionality of the optoelectronic foil, since it aims to reduce the ingress of water, oxygen and other potentially harmful factors towards the optoelectronic device and its sensitive parts. The optoelectronic foil with increased functionality of the present disclosure is suitable to be applied in optoelectronic devices, such as photovoltaic devices. This optoelectronic foil provides a ready solution, on which optoelectronic devices may be formed and the process of forming optoelectronic devices on said optoelectronic foil is easier and less invasive for sensitive barrier structures. There is reduced need to apply only non-invasive or highly precise deposition and treatment techniques, or to take extra care when depositing subsequent layers, which makes the optoelectronic foil of the present disclosure particularly suitable for such applications, since practicability and simplicity of further processes is increased. The barrier layer of the optoelectronic foil is uniform and continuous, as the risk of damaging the barrier layer by subsequent processing steps is reduced.

In another aspect, the invention relates to an optoelectronic device comprising the optoelectronic foil according to the disclosure. The optoelectronic device equipped with the optoelectronic foil according to the invention presents better durability and potentially longer lifespan, since the optoelectronic foil aims to protect the sensitive parts of the optoelectronic device from external factors, such as water, oxygen and the like, and the barrier layer is uniform and undamaged by the processes used to form the optoelectronic device on the optoelectronic foil. Additionally, the optoelectronic device equipped with said optoelectronic foil presents better work efficiency due to high conductivity of the electrode layer of the optoelectronic foil. The optoelectronic device may be selected from any optoelectronic device, such as a photovoltaic device, a light-emitting device, a photodiode, a phototransistor, a photomultiplier, a photo resistor, a photo detector, a light-sensitive detector, a solid-state triode, a battery electrode, a light-emitting diode, a laser, etc. Preferably the optoelectronic device is a photovoltaic device. The photovoltaic device comprises the optoelectronic foil with the structured electrode layer according to this disclosure. The disclosed structured electrode layer is especially effective when applied in photovoltaic devices. This is because the structured electrode layer allows to separate individual solar cells to form a photovoltaic module, making it an excellent choice for optimizing the performance of photovoltaic devices. Additionally, the flexibility and durability of the optoelectronic foil ensure long-lasting and reliable operation, further contributing to the overall efficiency and sustainability of the devices.

### BRIEF DESCRIPTION OF THE DRAWINGS

Aspects and features of the present invention will become apparent by describing, in detail, exemplary embodiments of the present invention with reference to the attached drawings, in which:
Fig. 1a schematically shows the block diagram of the method for manufacturing an optoelectronic foil according to an embodiment of present disclosure.
Fig. 1b schematically shows the block diagram of the method for manufacturing an optoelectronic foil according to another embodiment of the present disclosure.
Fig. 2 schematically shows cross-section of the structure of the optoelectronic foil according an example of the present disclosure.
Fig. 3 schematically shows cross-section of the structure of the optoelectronic foil according to an example of the present disclosure.
Fig. 4 schematically shows cross-section of the structure of the optoelectronic foil according to an example of the present disclosure.
Fig. 5 schematically shows cross-section of the structure of the optoelectronic foil according to an example of the present disclosure.
Fig. 6 schematically shows cross-section of the structure of the optoelectronic device according to an example of the present disclosure.
Fig. 7 shows an optical microscope image of the optoelectronic foil according to an embodiment of the invention after the step of treating the electrode layer.
Fig. 8 shows HeTR (helium transmission rate) analysis of the optoelectronic foil according to an embodiment of the present disclosure.
Fig. 9 shows light-transmittance of the optoelectronic foil according to an embodiment of the present disclosure.

### DETAILED DESCRIPTION OF EMBODIMENTS

Reference will now be made to embodiments, examples of which are illustrated in the accompanying drawings. Aspects and features of the invention will be described with reference to the accompanying drawings. In the drawings, like reference numerals denote like elements. The present invention, however, may be embodied in various different forms and should not be construed as being limited only to the illustrated embodiments. Rather, the presented embodiments are provided as examples so that this disclosure will be thorough and complete, and will fully convey the aspects and features of the present invention to those skilled in the art. It shall be understood that not all of the features shown in the embodiment are essential and the scope of the protection is defined not by means of literally shown embodiment, but by the features provided in the claims.

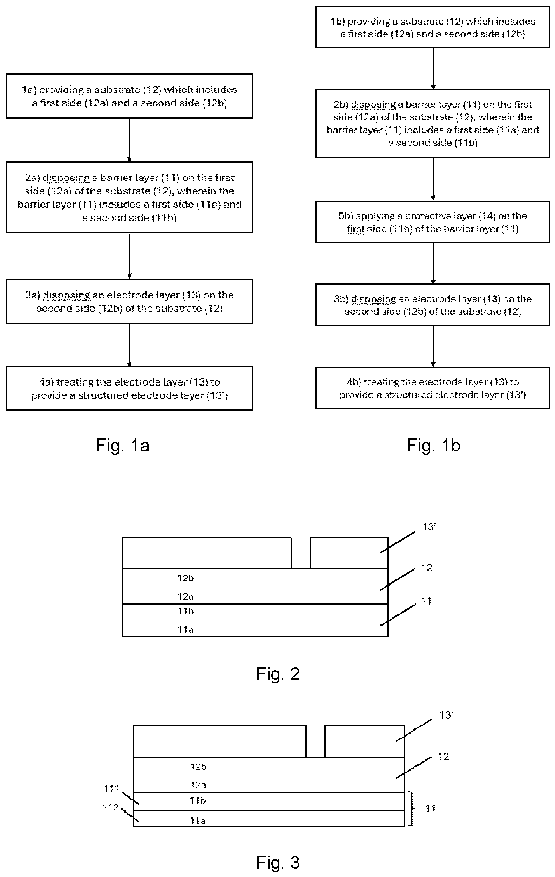

Fig. 1a schematically shows a block diagram of a method for manufacturing an optoelectronic foil. Step 1a comprises providing a substrate 12 which includes a first side 12a and a second side 12b. Step 2a comprises depositing a barrier layer 11 on the first side 12a of the substrate 12, wherein the barrier layer 11 includes a first side 11a and a second side 11b. The second side 11b of the barrier layer 11 is adjacent to the first side 12a of the substrate 12. Step 3a comprises depositing an electrode layer 13 on the second side 12b of the substrate 12. The deposition technique for the barrier layer 11 and the electrode layer 13 on the substrate 12 is not particularly limited. Preferably, the barrier layer 11 is deposited on the substrate 12 using any deposition technique selected from atomic layer deposition (ALD), molecular layer deposition (MLD), sputtering (magnetron sputtering or E-beam sputtering), thermal evaporation, chemical vapor deposition, pulsed laser deposition, or similar. Preferably, the electrode layer 13 is deposited on the substrate 12 using any deposition technique selected from atomic layer deposition (ALD), sputtering (magnetron sputtering or E-beam sputtering), thermal evaporation, pulsed laser deposition, or similar. Any of the abovementioned deposition techniques allows to effectively form the desired layers of high quality and uniformity. The ALD technique allows precise control over the thickness and composition of the layer, allowing for the creation of uniform and high-quality coatings. Sputtering technique provides the ability to deposit thin layers of various materials with high uniformity at low temperatures, which is crucial for sensitive and/or flexible substrates. The sputtering technique enables control over various properties of the deposited layer by adjusting process parameters such as gas pressure, deposition time, temperature, and gas atmosphere composition. Thermal evaporation technique provides advantages including simplicity, high deposition rates, and suitability for a wide range of materials. Since the deposition technique is not particularly limited, a suitable technique may be selected to obtain optimized layer properties, such as thickness and homogeneity, and process practicability and cost-effectiveness may be achieved. The deposition technique for the barrier layer 11 is not particularly limited, as long as it enables the formation of layers with desired properties, so that barrier functionality is achieved. Preferably, the barrier layer 11 is deposited using ALD or sputtering. The deposition technique for the electrode layer 13 is also not particularly limited, as long as a layer with desired thickness and conductivity is obtained. Since the electrode layer 13 is deposited on the opposite side of the substrate 12 from the barrier layer 11, its deposition technique is not limited to only non-invasive techniques. The risk of damaging the sensitive barrier layer 11 is reduced by separating it from the electrode layer 13, so that the barrier properties are retained independently of the selected deposition technique for the electrode layer 13. This enhances the practicability of the process, as the deposition technique for the electrode layer 13 is not particularly limited. Preferably, the barrier layer 11 and the electrode layer 13 are deposited using the same technique. The process of depositing those layers using the same technique is advantageous, since less processing equipment may be used and the deposition may be faster and less complicated. Preferably, the barrier layer 11 and the electrode layer 13 are deposited by sputtering technique. Preferably, they are deposited using the same sputtering system, which brings benefits such as speeding up the deposition process and reducing associated costs. The same applies to the sublayers if they are present within any of the layers: the barrier layer 11, the electrode layer 13.

Step 4a of the method for manufacturing the optoelectronic foil comprises treating the electrode layer 13 to provide a structured electrode layer 13'. The structured electrode layer 13' increases the functionality of the optoelectronic foil, as described above. The disclosed structure of the optoelectronic foil enables the electrode layer 13 to be treated to achieve the structured electrode layer 13'. The step of treating the electrode layer 13 may include one of the techniques selected from the group consisting of: laser ablation, chemical etching, mechanical scribing, and the like. These techniques may be considered invasive and potentially harmful to the underlying layers. Especially in cases when the underlying layers are particularly sensitive to damage. The developed method for manufacturing the optoelectronic foil according to this disclosure allows improved electrode layer 13 treatment possibilities without damaging the barrier layer 11, as the substrate 12 is provided between the electrode layer 13 and the barrier layer 11. Thus, the performed treatment does not impair or reduce the risk of impairment of the barrier properties of the barrier layer 11.

Fig. 1b schematically shows a block diagram of the method for manufacturing the optoelectronic foil according to an embodiment of the present disclosure. The method includes steps 1b, 2b, 3b, 4b which correspond to steps 1a, 2a, 3a, 4a described above. The method according to this embodiment comprises an additional step 5b of disposing a protective layer 14 on the first side 11a of the barrier layer 11. This step may be performed after the barrier layer 11 has been disposed on the substrate 12. The process of depositing the protective layer 14 on the barrier layer 11 is not particularly limited and may be carried out by any suitable technique, as long as it allows to obtain a good quality, uniform protective layer. The protective layer 14 may be deposited by laminating the protective layer 14 in the form of a polymeric foil on the barrier layer 11. The protective layer 14 may also be deposited using a solution-based coating technique, such as, but not limited to, ink-jet printing, slot-die coating, blade-coating, gravure printing, spray coating, screen-printing, and similar. The process of depositing the protective layer 14 on the barrier layer 11 according to this embodiment allows to form a relatively homogeneous layer of superior protective properties. The protective layer 14 provides protection for the barrier layer 11 against external factors, mechanical damage and other potentially harmful factors, that may affect the barrier layer 11 after it is formed on the substrate 12 of the optoelectronic foil. The protective layer 14 also protects the barrier layer 11 after the optoelectronic foil is manufactured and transported as a component for subsequent manufacturing of the optoelectronic device equipped with the optoelectronic foil. The protective layer 14 also protects the optoelectronic device from external, potentially harmful factors and aims to improve the working conditions of the optoelectronic device by reducing the ingress of water and oxygen, as well as protecting sensitive parts of the optoelectronic device from damage.

In the embodiments of manufacturing the of optoelectronic foil presented in Fig. 1a and Fig. 1b, the order of applying the layers is essentially arbitrary. Preferably, the sequence of steps is: step 1a, 2a, 3a, 4a, or 1b, 2b, 3b, 4b, 5b. Such a sequence of steps allows to obtain the optoelectronic foil of improved functionality and with reduced risk of damaging the barrier layer 11 by downstream manufacturing process. The steps 3a and 4a, or 3b and 4b of disposing and treating the electrode layer 13 is less harmful or not harmful for the barrier layer 11, because the barrier layer 11 is deposited on the opposite side of the substrate 12, which substrate 12 provides additional protection for the barrier layer 11. Preferably, the sequence of steps is: step 1a, 3a, 2a, 4a or 1b, 3b, 2b, 4b, 5b. Such a sequence of steps also allows to obtain the optoelectronic foil of improved functionality and with reduced risk of damaging the barrier layer 11 by downstream manufacturing process. This is due to the fact, that the step 3a or 3b of disposing the electrode layer 13 on the substrate 12 is carried out before the step 2a or 2b of disposing the barrier layer 11 on the substrate 12 is carried out which is why, this step will not affect the barrier layer 11. Preferably, the sequence of steps is: step 1a, 3a, 4a, 2a or 1b, 3b, 4b, 2b, 5b. Such a sequence of steps allows to obtain the optoelectronic foil of improved functionality according to the present disclosure in which the risk of damaging the barrier layer by the downstream manufacturing process is further reduced. This is due to the fact, that the steps 3a and 4a or 3b and 4b of disposing and treating the electrode layer 13 on the substrate 12 are carried out before the step 2a or 2b of disposing the barrier layer 11 on the substrate 12 are carried out which is why, these step will not affect the barrier layer 11. It should be noted, that the step 5b of applying the protective layer 14 on the barrier layer 11 may be carried out after step 2a or 2b of depositing the barrier layer 11 on the substrate 12. As such, preferably, the sequence of steps is 1b, 2b, 5b, 3b, 4b or 1b, 3b, 2b, 5b, 4b. The step 5b of depositing the protective layer 14 on the barrier layer 11 provides additional protection for the barrier layer 11 during the manufacturing process.

Fig. 2 schematically shows the optoelectronic foil manufactured by the method according to the present disclosure. It also schematically shows the optoelectronic foil of the present disclosure manufactured by other known means. Preferably, the optoelectronic foil is provided as a deformable, e.g., flexible, light-transmissive (transparent, or translucent) foil. The optoelectronic foil comprises a substrate 12, a barrier layer 11 arranged on the first side 12a of the substrate 12 and an electrode layer 13 arranged on the second side 12b of the substrate 12. Preferably, the electrode layer 13 is treated to form the structured electrode layer 13'. The disclosed design, and further developed architecture of said two layers (the electrode layer 13 and barrier layer 11) as well as selected properties of materials used in these layers, together provide improved characteristics of the optoelectronic foil, including high barrier properties, enhanced chemical and thermal stability, high flexibility and high light transmission of the entire stack. Additionally, the structured electrode layer 13' provides additional functionality compared to the non-structured electrode layer 13.

The optoelectronic foil comprises the substrate 12, which is preferably deformable, such that the substrate 12 is flexible. The substrate 12 may be made of various transparent or translucent materials, and preferably those providing deformability to the substrate 12. For example, the substrate 12 may comprise foil or may be substantially entirely made of foil, optionally with a primer coating provided on the foil surface. The preferred, non-limiting examples of plastic materials that are suitable to be used for the substrate 12 are at least one material selected from the group consisting of polyethylene terephthalate (PET), polyethylene naphthalene (PEN), polyethylene (PE), polypropylene (PP), polyethersulfone (PES), polyimide (PI), polystyrene (PS), ethylene/tetrafluoroethylene (ETFE) and parylene or mixture(s) thereof. The thickness of the substrate 12 is not particularly limited and it depends on the needs. For example, the substrate 12 may be of thickness from 25 to 300 microns. The flexibility of the substrate 12 and thickness versatility allows for compatibility with diverse device designs, accommodating bends and curves of the application surface without compromising performance. Furthermore, the choice of flexible substrates enhances the optoelectronic foil adaptability to various manufacturing processes, facilitating seamless integration into optoelectronic devices.

The optoelectronic foil further comprises the barrier layer 11. Preferably, the barrier layer takes the form of a monolayer structure consisting of the barrier monolayer made of only one material, selected from the group consisting of aluminum oxides (AlOₓ), titanium oxides (TiOₓ), tin oxides (SnOₓ), zirconium oxides (ZrOₓ), hafnium oxides (HfOₓ), zinc oxides (ZnOₓ), silicon oxides (SiOₓ), chromium oxides (CrOₓ), silicon oxynitrides (SiOₓN_{y}), silicon nitrides (SiNₓ), organic silicon compounds (SiCₓH_{y}), and zinc tin oxides, ZTO (ZnSnₓO_{y}). The thickness of the barrier layer 11 consisting of the barrier monolayer may be between 5 to 120 nm. Preferably, the thickness of the barrier layer 11 consisting of the barrier monolayer is selected from 5 to 50 nm, such as 10 to 30 nm for the barrier monolayer formed by ALD. Preferably, the thickness of the barrier layer 11 consisting of the barrier monolayer is 40 to 120 nm for the barrier monolayer formed by sputtering. The barrier layer 11 having thickness selected from this range provides desired barrier properties and light-transmittance. Preferably, in some embodiments the barrier layer 11 is made of AlOₓ. Alternatively, in some embodiments the barrier layer 11 is made of ZTO.

The optoelectronic foil further comprises the electrode layer 13. Preferably, the electrode layer 13 takes the form of a monolayer structure consisting of a material selected from the group of transparent conductive oxides (TCO) consisting of indium oxide (In2O3), tin oxide (SnO2), zinc oxide (ZnO), vanadium oxide (V2O5), molybdenum oxide (MoO3), tungsten oxide (WO3), tin indium oxide (ITO), indium zinc oxide (IZO), aluminum zinc oxide (AZO) and indium gallium zinc oxide (IGZO). Alternatively, the monolayer structure of the electrode layer 13 may consist of a material selected from the group of metals consisting of: copper (Cu), silver (Ag), nickel (Ni) chrome (Cr) and titanium (Ti). The monolayer structure of the electrode layer 13 may consist of a single material or of at least two mixed materials selected from the group above to form a an alloy, e.g., a bimetallic alloy consisting of two metals. The thickness of the electrode layer 13 in the form of the monolayer structure is not particularly limited. For example, the thickness of the monolayer structure of the electrode layer 13 may be selected from 10 nm to 500 nm. Preferably, the thickness of the monolayer structure of the electrode layer 13 consisting of the oxide layer is 20 nm to 500 nm, and more preferably 60 nm to 300 nm. Preferably, the thickness of the monolayer structure of the electrode layer 13 consisting of the metal layer is selected from 4 to 12 nm. The electrode layer 13 of the monolayer structure having thickness from this range provides desired light-transmittance, conductivity and durability, as well as the monolayer structure provides simplicity in the manufacturing process.

The optoelectronic foil according to this embodiment as presented in Fig. 2 and disclosed arrangement of layers as well as selection of materials and layer thicknesses provides the optoelectronic foil with superior functionality, desired barrier properties, conductivity and light-transmittance which improves the overall characteristics of the optoelectronic foil and makes it suitable to be applied in optoelectronic devices.

Fig. 3 schematically shows the optoelectronic foil manufactured by the method according to the present disclosure. It also schematically shows the optoelectronic foil of the present disclosure manufactured by other known means. The optoelectronic foil presented in Fig. 3 corresponds essentially to the optoelectronic foil presented in Fig. 2, with the difference being the barrier layer 11 taking form of a multilayer structure. The barrier layer 11 of the optoelectronic foil presented in Fig. 3 takes the form of the multilayer structure comprising at least two barrier sublayers made of the same or different materials selected from the group of materials mentioned above with reference to Fig. 2. Preferably, the barrier layer 11 comprises two or more than two barrier sublayers to further improve barrier and optical properties of the barrier layer 11. Preferably, the barrier layer 11 according to this embodiment comprises a first barrier sublayer 111 and a second barrier sublayer 112. Such arrangement provides additional benefit of multiplying properties of each of the sublayers within the barrier layer 11. It may improve barrier properties of the barrier layer 11 by enhancing moisture and oxygen resistance and mitigating the effect of defects and pinholes created in single layers. Also, the barrier layer 11 having a multilayer structure may be designed to optimize optical properties, such as transparency and reflectivity, which is important in optoelectronic devices equipped with optoelectronic foils. Each of the first and the second barrier sublayers may be made of the material selected from the group of materials for the barrier monolayer, as described above. The total thickness the barrier layer 11 comprising the first barrier sublayer 111 and the second barrier sublayer 112 may selected from the range of 5 nm to 150 nm, such as 5 nm to 50 nm when the ALD technique is used and 40 nm to 150 nm when the sputtering technique is used to form the first and the second barrier sublayer. The barrier layer 11 of this thickness range is particularly beneficial, since not only it enables desired barrier and transparency properties, but also it allows to use less material and assists in making the optoelectronic foil more flexible and lighter. Preferably the first barrier sublayer 111 is made of AlOₓ and the second barrier sublayer 112 is made of TiOₓ. Preferably the first barrier sublayer 111 is made of AlOₓ and the second barrier sublayer 112 is made of ZnOₓ. Such arrangement provides enhanced optical properties. It should be noted, that the order of barrier sublayers 111 and 112 may be reversed.

The barrier layer 11 taking the form of the multilayer structure according to the embodiment presented in Fig. 3 may additionally comprise the third sublayer (not shown in Fig. 3). The third sublayer may be made of the material selected from the group of materials for the barrier monolayer, as described above with reference to Fig. 2. The presence in the third sublayer may further enhance its barrier and optical properties of the barrier layer. It should be understood, that the number of barrier sublayers is not particularly limited and the barrier layer 11 may comprise more than 3 sublayers.

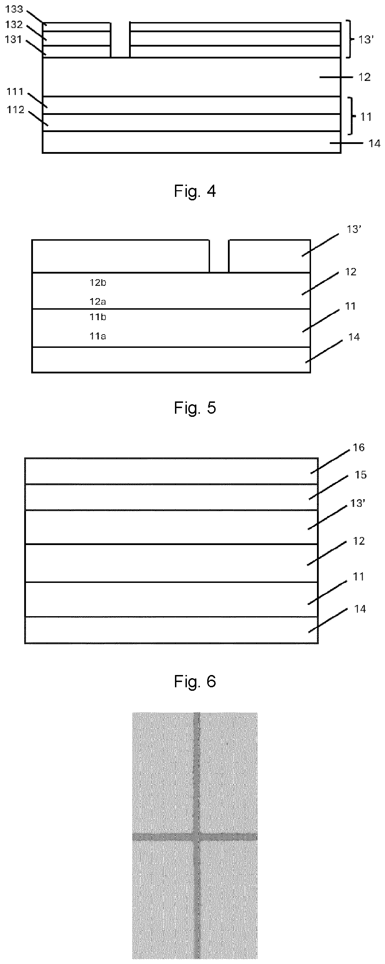

Fig. 4 schematically shows the optoelectronic foil manufactured by the method according to the present disclosure. It also schematically shows the optoelectronic foil of the present disclosure manufactured by other known means. The optoelectronic foil presented in Fig. 4 corresponds essentially to the optoelectronic foil presented in Fig. 3, with the difference being the electrode layer 13 taking form of a multilayer structure.

The optoelectronic foil comprises the electrode layer 13. Preferably, the electrode layer 13 takes form of a multilayer structure. As such, preferably, the electrode layer 13 comprises the metal layer 132, the first oxide layer 131 and the second oxide layer 133, so that the metal layer 132 is sandwiched between the first oxide layer 131 and the second oxide layer 133, and the first oxide layer 131 is adjacent to the substrate 12 and the second oxide layer 133 is facing away from the substrate 12. Such arrangement provides benefits, such as higher conductivity and improved light transmission in visible range for high conductivity regime, when compared to the electrode layer 13 of the monolayer structure. The metal layer 132 comprises a layer of metal. Preferably, the metal layer 132 is a single layer of metal selected from Ag, Au, Al, Cu, Ti, Ge, Zn and Cr. The single layer of metal provides desired conductivity, durability and simplicity of the deposition process. Preferably, the metal layer 132 is a single layer of two or more metals in a form of metallic alloy, e.g., bimetallic alloy. Preferably, the metal layer 132 is a multilayer structure comprising at least two metal sublayers, where each metal sublayer is preferably made of one or more metal type, or metallic alloy of different metals. The metal layer 132 comprising two or more metal materials may provide enhanced performance, since the conductivity and mechanical robustness can be increased. The first oxide layer 131 and the second oxide layer 133 of the electrode layer 13 may be in the form of a monolayer structure or a multilayer structure. Preferably, they are of the monolayer structure. As such, the first and the second oxide layers are made of one or more than one TCO (transparent conductive oxide), preferably selected from the group consisting of indium oxide (In₂O₃), tin oxide (SnO₂), zinc oxide (ZnO), vanadium oxide (V₂O₅), molybdenum oxide (MoOs), tungsten oxide (WOs), or complex metal oxides containing at least one of the metal atoms selected from the group consisting of In, Sn, Zn, V, Mo and W, mentioned above and another dopant metal, within the complex oxide structure, such as, e.g., tin indium oxide (ITO), indium zinc oxide (IZO), aluminum zinc oxide (AZO), and indium gallium zinc oxide (IGZO) or similar complex metal oxides. Preferably, the first and the second oxide layers 131, 133 are of the multilayer structure in order to further increase their functionality.

Preferably the electrode layer 13 consists of the metal layer 132 and the second oxide layer 133, such that the metal layer 132 is adjacent to the substrate 12, and the second oxide layer 133 is facing away from the substrate 12. Such arrangement of the electrode layer 13 provides higher conductivity and improved light transmission in the visible range when compared to the embodiment of the electrode layer 13 of the monolayer structure, as described above.

It should be noted, that the barrier layer 11 may be in the form of either the monolayer or the multilayer structure, and the electrode layer 13 may be in the form of either the monolayer or the multilayer structure within the optoelectronic foil according to the present disclosure.

Fig. 5 schematically shows the optoelectronic foil manufactured by the method according to the present disclosure. It also schematically shows the optoelectronic foil of the present disclosure manufactured by other known means. The optoelectronic foil presented in Fig. 5 corresponds essentially to the optoelectronic foil presented in Fig. 2, with the difference of the presence of the protective layer 14. As such, the optoelectronic foil additionally comprises the protective layer 14 disposed on the first side 11a of the barrier layer 11, such that the protective layer 14 is disposed on the opposite side of the barrier layer 11 to the substrate 12. The protective layer 14 has a barrier function and protects the barrier layer 11 from physical damages, ensuring consistent performance even in challenging environments. In some embodiments, in which the barrier layer 11 is formed of the multilayer structure and comprises more than one barrier sublayer, the protective layer is deposited on the outermost layer of the multilayer structure of the barrier layer 11 when looking from the side of the substrate 12. The protective layer 14 may be in the form of a polymeric foil laminated on the barrier layer 11. As such, the protective layer 14 is preferably made of at least one material selected from the group consisting of polyolefins, preferably polypropylene, polyethylene, and/or low density polyethylene, ionomers, acrylates, polyester. The protective layer 14 may be in the form of a coating deposited by solution-based coating techniques. As such, the protective layer is preferably made of a material selected from the group consisting of acrylate-based polymers, epoxy-based polymers or polyolefins, such as, but not limited to polymethyl methacrylate (PMMA) or poly(methyl methacrylimide) (PMMI). The protective layer 14 may take form of a monolayer structure or a multilayer structure comprising more than one protective sublayers. Preferably, the protective layer 14 has a thickness between 2 µm and 200 µm.

Fig. 6 schematically shows a structure of an optoelectronic device according to the present invention. The optoelectronic foil can be used in forming the optoelectronic device, such as the optoelectronic device may be formed directly on the optoelectronic foil. The optoelectronic device comprises the optoelectronic foil according to the disclosure, a photoactive stack 15 and a back electrode layer 16 which are arranged in a stack on the top of each other in sequence: the optoelectronic foil, the photoactive stack 15, the back electrode layer 16. The optoelectronic foil is suitable to be applied in optoelectronic devices, such as photovoltaic devices, which are sensitive to environmental factors and need conductive layer, thanks to its improved barrier properties. Also, the optoelectronic foil provides increased functionality due to the presence of the structured electrode 13', which makes the optoelectronic foil particularly suitable in optoelectronic devices in which such structured electrode layers 13' are desired, such as photovoltaic devices. The structured electrode layer 13' may comprise discontinuities created by cuts, resulting in separate, electrically isolated electrode regions on the surface of the electrode layer. Such arrangement aims to minimize electrical resistance of the electrode layer and provide optimized performance, functionality and efficiency of optoelectronic devices, since they provide better electrical charge distribution and reduced resistive loses. The optoelectronic foil with such structured electrode layer is particularly suitable for use in photovoltaic devices in which the structured electrode layer involving grooves or scribe lines provide electrical isolation between adjacent solar cells on the same substrate. The charge carriers generated in the photovoltaic device are efficiently collected and transported in order to enhance the efficiency in converting sunlight into electrical energy. Structured electrode layer also facilitates interconnection of solar cells to form photovoltaic modules comprising said solar cells connected in series. Series connection of solar cells in photovoltaic modules allow to multiply the voltage generated by each of the solar cells, so that the overall voltage provided by the photovoltaic module is increased. Thanks to the described construction and the set of materials, the optoelectronic device employed with the optoelectronic foil according to this disclosure will exhibit particularly good properties such as high efficiency, enhanced durability, and superior sensitivity to light. The electrode layer 13 can be arranged preferably as a front electrode, either as cathode or anode - in various designs of optoelectronic devices, for example, with perovskite or organic light-sensitive region (e.g. OLEDs), depending on the needs. Preferably, the electrode layer 13 takes form of the structured electrode layer 13'. Additionally, different manufacturing techniques may be used to produce the optoelectronic device on the optoelectronic foil according to this disclosure, with reduced risk of damaging the sensitive barrier structure, thanks to the specific design of the optoelectronic foil being part of this invention. The ability to use various deposition techniques in different configurations (other technique for each layer) enables the customization of the device architecture to meet specific performance and design requirements. This makes the optoelectronic foil more practical.

Fig. 7 shows an optical microscope image of the optoelectronic foil according to an embodiment of the invention after the step of treating the electrode layer 13.

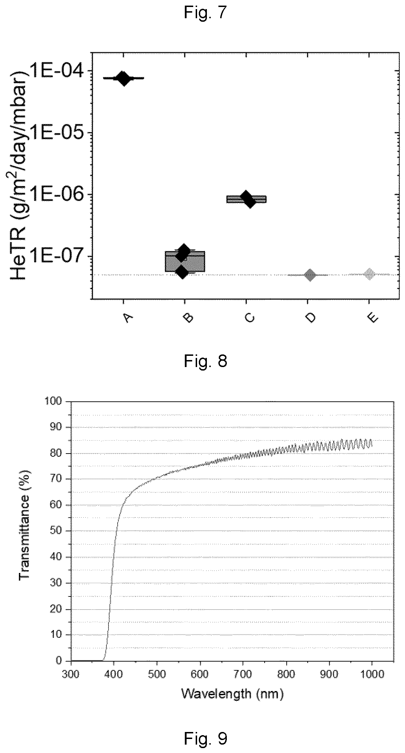

Fig. 8 shows HeTR (helium transmission rate) analysis of the optoelectronic foil according to an embodiment of the present disclosure and presents five measurements (A-E). The first measurement A corresponds to the barrier properties of PET foil. The second measurement B corresponds to the barrier properties of a standard optoelectronic foil known in the art comprising a PET substrate, a barrier structure and an electrode structure in this order, before the step of treating the electrode structure with laser to perform P1 patterning. The third measurement C corresponds to the barrier properties of the same standard optoelectronic foil known in the art after the step of treating the electrode structure with laser to perform P1 patterning. The forth measurement D corresponds to the to barrier properties of the optoelectronic foil according to the present disclosure before the step of treating the electrode layer. The fifth measurement E corresponds to the barrier properties of the optoelectronic foil according to the present disclosure after the step of treating the electrode layer. As can be seen, the barrier properties of the optoelectronic foil according to the present disclosure were not affected by the treatment step of the electrode layer. The barrier properties of the optoelectronic foil known in the art were deteriorated (see measurement B and C).

Fig. 9 shows light-transmittance of the optoelectronic foil according to an embodiment of the present disclosure in the visible range (400 nm - 800 nm).

### Example 1

The optoelectronic foil according to the Example 1 is schematically shown in Fig. 3. The optoelectronic foil comprises the substrate 12, the barrier layer 11 deposited on the first side 12a of the substrate 12 and the electrode layer 13 deposited on the second side 12b of the substrate 12. The electrode layer 13 is treated to form the structured electrode layer 13'. The barrier layer 11 forms a multilayer structure, and the structured electrode layer 13' forms a monolayer structure.

The manufacturing method is shown schematically in Fig. 1a and comprises the steps of:
1a) Providing the substrate 12, which is a deformable, flexible foil made of PET, cleaning and activating the substrate 12.
2a) Forming the barrier layer 11 on the substrate 12 by depositing the first barrier sublayer 111 on the first side 12a of the substrate by sputtering and depositing the second barrier sublayer 112 on the first barrier sublayer 11 by sputtering. The first barrier sublayer 111 is made of ZnSnₓO_{y} (ZTO) and has a thickness of 60 nm. The second barrier sublayer 112 is made of silicon oxide (SiOₓ) and has a thickness of 40 nm. Alternatively, the thicknesses of the barrier layer sublayers 111 and 112 may be selected, so that the total thickness of the barrier layer 11 is selected from 50 nm to 150 nm, such as 50 nm, 60 nm, 70 nm, 80 nm or 90 nm, 100 nm, 110 nm, 120 nm, 130 nm, 140 nm, 150 nm, as long as desired barrier and optical properties are obtained.
3a) Depositing the electrode layer 13 on the second side 12b of the substrate 12 by sputtering. The electrode layer 13 is made of indium tin oxide (ITO) and has a thickness of 100 nm. Alternatively, the thickness of the electrode layer 13 may be selected from 60 nm to 300 nm, such as 60 nm, 150 nm, 200 nm, 250 nm or 300 nm as long as desired electrical and optical properties are obtained.
4a) Treating the electrode layer 13 by laser ablation to provide the structured electrode layer 13'.

The optoelectronic foil exhibits improved barrier properties, water vapor transmission rate (WVTR) 1×10⁻⁶ - 1×10⁻² g/m² per day at 38°C / 90 % RH (Relative Humidity), higher flexibility - no changes are observed in barrier properties of the optoelectronic foil upon its bending with radius even as low as 0,5 cm (wherein the higher the bending radius the lower the curvature). Furthermore, the developed optoelectronic foil features improved light transmission of over 70% AVT (average visible transmission), and low sheet resistance - below 60 Ohms/sq.

### Example 2

The optoelectronic foil according to the Example 2 is schematically shown in Fig. 4. The optoelectronic foil corresponds essentially to the optoelectronic foil presented in Fig. 3. The barrier layer 11 forms a multilayer structure, and the structured electrode layer 13' forms a multilayer structure. The optoelectronic foil additionally comprises the protective layer 14, which is adjacent to the first side 11a of the barrier layer 11.

The manufacturing method is shown schematically in Fig. 1b and comprises the steps of:
1b) Providing the substrate 12 (the step corresponds to step 1a of Example 1).
2b) Forming the barrier layer 11 on the substrate 12 by depositing the first barrier sublayer 111 on the first side 12a of the substrate 12 by ALD and depositing the second barrier sublayer 112 on the first barrier sublayer 111 by ALD. The first barrier sublayer layer 111 is made of aluminum oxide (AlOₓ) and has a thickness of 30 nm. The second barrier sublayer layer 112 is made of titanium oxide (TiOₓ) and has a thickness of 5 nm. The total thickness of the barrier layer 11 is 35 nm. Alternatively, the thicknesses of the barrier sublayers 111, 112 may be selected, so that the total thickness of the barrier layer 11 is from the range of 5 - 50 nm, such as 5 nm, 10 nm, 20 nm, 30 nm, 40 nm, 50 nm, as long as desired barrier and optical properties are obtained.
5b) Forming the protective layer 14 on the barrier layer 11 by laminating the ethylene based polymeric foil on the first side 11a of the barrier layer 11. The protective layer 14 has a thickness of 50 µm.
3b) Forming the electrode layer 13 on the substrate 12 by depositing the first oxide layer 131 on the second side 12b of the substrate 12, depositing the metal layer 132 on the first oxide layer 131, and depositing the second oxide layer 133 on the metal layer 132, wherein the deposition steps are done by sputtering. The first oxide layer 131 is made of ITO and of has a thickness of 35 nm, the metal layer 132 is made of silver and has a thickness of 8 nm, the second oxide layer 133 is made of ITO and has a thickness of 35 nm. The electrode layer 13 has a total thickness of 78 nm.

Alternatively, the thickness of the metal layer 132 may be selected from the range of 4 nm to 12 nm. The thickness of first oxide layer 131 may be selected from 1 nm to 60 nm, such as 1 nm, 10 nm, 20 nm, 30 nm, 40 nm, 50 nm or 60 nm. The thickness of second oxide layer 133 may be selected from 5 nm to 60 nm, such as 5 nm, 10 nm, 20 nm, 30 nm, 40 nm, 50 nm or 60 nm. The total thickness of the electrode layer 13 may be selected from the range of 10 nm to 132 nm, such as 10 nm, 30 nm, 50 nm, 70 nm, 90 nm, 110 nm, 130 nm, as long as desired electrical and optical properties are obtained.

Alternatively, the metal layer 132 is of a multilayer structure. The metal layer 132 comprises two metal sublayers formed by sputtering, in which the first metal sublayer is formed on the second side 12b of the substrate 12 and it is made of Cu and the second metal sublayer is formed on the first metal sublayer and it is made of Ag. Alternatively, the metal layer 132 forms a single layer of Cu/Ag alloy of Cu = 10 at% and Ag = 90 at% and it is formed by sputtering, and more preferably by co-sputtering where two separate metals, Ag and Cu, are used. By co-sputtering it is possible to make metal layers with a thickness as low as 4 nm, which provides very good conductivity with Rsh ≤20 Ohm/sq. Optionally, co-sputtering of a single Ag/Cu alloy target can be used. The thickness of the metal layer 132 corresponds essentially to the thickness of the metal layer 132 as disclosed in the paragraph above.
4b) Treating the electrode layer 13 by chemical etching to provide the structured electrode layer 13'.

The optoelectronic foil exhibits desired barrier properties as well as desired light-transparency and conductivity, so that it is suitable to be used in optoelectronic devices.

### Example 3

The optoelectronic foil according to the Example 3 is shown in Fig. 5. The optoelectronic foil has a structure substantially similar to the structure of the optoelectronic foil shown in the Example 1. For clarity of the present disclosure, a description of similar elements and their features is omitted.

The barrier layer 11 is of the monolayer structure and is deposited on the first side 12a of the substrate 12 by sputtering. The barrier layer 11 is made of ZnSnₓO_{y} (ZTO) and has a thickness of 80 nm. Alternatively, the thickness of the barrier layer 11 may be selected from 40 nm to 120 nm, such as 40 nm, 50 nm, 60 nm, 70 nm,80 nm, 90 nm, 100 nm, 110 nm or 120 nm, as long as desired barrier and optical properties are obtained.

The protective layer 14 is deposited on the barrier layer 11 by ink-jet printing polymethyl methacrylate (PMMA) on the first side 11a of the barrier layer 11. It should be noted that other suitable materials may be used, as long as desired properties are obtained.

The electrode layer 13 corresponds to the electrode layer 13 of the Example 1 and it is formed on the second side 12b of the substrate 12 by sputtering. The electrode layer 13 is made of ITO. The electrode layer 13 is treated by laser etching to form the structured electrode layer 13'. The optical microscope image of the optoelectronic foil according to this example is presented in Fig. 7.

The optoelectronic foil exhibits improved barrier properties, water vapor transmission rate (WVTR) 1.15×10⁻³ g/m² per day at 38°C / 90 % RH (Relative Humidity), helium transmission rate (HeTR) 1×10⁻⁷ g/m²/day/mbar (as shown in Fig. 8), higher flexibility - no changes are observed in barrier properties of the optoelectronic foil upon its bending with radius even as low as 0,5 cm (wherein the higher the bending radius the lower the curvature). Furthermore, the developed optoelectronic foil features improved light transmission of over 73.6% AVT (average visible transmission), as shown of Fig. 9, and low sheet resistance - below 60 Ohms/sq.

### Example 4

Example 4 of the invention is the optoelectronic device which is a photovoltaic device and it is illustrated on the Fig. 6.

The photovoltaic device comprises the optoelectronic foil according to the Example 3, the photoactive stack 15 and the back electrode layer 16 which are arranged in a stack on the top of each other in sequence: the optoelectronic foil, the photoactive stack 15, the back electrode layer 16. The photoactive stack 15 is adjacent to the structured electrode layer 13' and the back electrode layer 16 is adjacent to the photoactive stack 15.

The back electrode layer 16 is made of carbon, and the photoactive stack 15 comprises ETL/perovskite/HTL structure formed by any known means.

The photovoltaic device may also comprise the optoelectronic foil according to any of the Examples 1 or 2.

## Claims

1. A method for manufacturing an optoelectronic foil, **characterized by** comprising the steps of:
a) providing a substrate (12) having a first side (12a) and a second side (12b),
b) disposing a barrier layer (11) on the substrate (12), wherein the barrier layer (11) has a first side (11a) and a second side (11b), and wherein the second side (11b) of the barrier layer (11) is adjacent to the first side (12a) of the substrate (12),
c) disposing an electrode layer (13) on the second side (12b) of the substrate (12),
d) treating the electrode layer (13) to provide a structured electrode layer (13').

2. The method according to claim 1, wherein the method comprises a step of applying a protective layer (14) on the first side (11a) of the barrier layer (11).

3. The method according to claim 1 or 2, wherein the step of treating the electrode layer (13) includes at least one technique selected from the group consisting of: laser ablation, chemical etching, and mechanical scribing.

4. The method according to any of the preceding claims, wherein the barrier layer (11) and the electrode layer (13) are deposited on the substrate (12) using the same deposition technique.

5. The method according to any of the preceding claims, wherein the barrier layer (11) is of a monolayer structure or a multilayer structure.

6. The method according to any of the preceding claims, wherein the barrier layer (11) has a total thickness of 5 nm to 150 nm.

7. The method according to any of the preceding claims, wherein the electrode layer (13) is of a monolayer structure or a multilayer structure.

8. The method according to any of the preceding claims, wherein the electrode layer (13) has a total thickness of 10 nm to 500 nm.

9. An optoelectronic foil for an optoelectronic device, manufactured by the method according to any of previous claims.

10. An optoelectronic foil for an optoelectronic device, comprising a substrate (12) having a first side (12a) and a second side (12b), a barrier layer (11) and a structured electrode layer (13'), **characterized in that** the structured electrode layer (13') is separated from the barrier layer (11) by the substrate (12) so that the barrier layer (11) is adjacent to the first side (12a) of the substrate (12) and the structured electrode layer (13') is adjacent to the second side (12b) of the substrate (12).

11. An optoelectronic device comprising the optoelectronic foil as defined in claim 9 or 10.
